# EUROPEAN PATENT SPECIFICATION

(11) **EP 0 529 593 B1**
(45) Date of publication and mention of the grant of the patent: **14.02.1996**
(21) Application number: 92114512.4
(22) Date of filing: 26.08.1992
(51) Int. Cl.: C23C 16/24, C01B 31/02, C23C 18/02, C23C 18/12

(54) **A glass carbon coated graphite chuck for use in producing polycrystalline silicon**
Mit glasigem Kohlenstoff überzogene Graphit-Spannvorrichtung zum Gebrauch bei der Erzeugung von polykristallinem Silizium
Madrin en graphite revêtu de carbone vitreux utile pour la fabrication de silicium polycristallin

(30) Priority: 29.08.1991 US 751968
(43) Date of publication of application: 03.03.1993
(73) Proprietor: UCAR CARBON TECHNOLOGY CORPORATION, Danbury, Connecticut 06817-0001 (US)
(72) Inventor: Lewis,Irwin Charles, Strongsville Ohio 44136 (US); Miller,Douglas J.(nmn), North Olmsted Ohio 44070 (US); Pirro,Terrence Anthony, Cleveland Ohio 44111 (US)
(74) Representative: Eggert, Hans-Gunther, Dr.

(56) References cited:
- DE-A- 4 041 901
- PATENT ABSTRACTS OF JAPAN, unexamined applications, C field, vol. 11, no. 229, July 25, 1987 THE PATENT OFFICE JAPANESE GOVERNMENT page 98 C 436
- PATENT ABSTRACTS OF JAPAN, unexamined applications, E field, vol. 9, no. 81,April 10, 1985, The Patent Office Japanese Government page 28 E 307

## Description

### BACKGROUND OF THE INVENTION

### Field of the Invention

This invention pertains to the field of producing substantially carbon-free polycrystalline silicon by the pyrolysis of a gaseous silicon compound. More specifically, the present invention relates to a graphite chuck having a hydrogen impervious outer layer of glassy carbon formed from a thermoset organic resin and in which the chuck is used to support a heated starter filament which thermally decomposes the gaseous silicon compound such that silicon is deposited on the starter filament without carbon contamination from the graphite chuck. The invention also relates to a method for producing the coated chuck.

### Background of the Invention

Polycrystalline silicon rods are primarily used as precursors for making single crystal rods for the semiconductor industry by either the float zone melting process or by the Czochralski crystal pulling technique. These single crystal rods are then processed to form silicon wafers from which silicon chips are made for use in the electronic industry.

Generally, polycrystalline rods are made by the pyrolytic decomposition of a gaseous silicon compound, such as silane or a chlorosilane (e.g., trichlorosilane) on a rod-shaped, red-heated starter filament made preferably from a silicon seed rod or, alternatively, from a high-melting point metal having good electrical conductivity such as tungsten or tantalum. The principles of the design of present state-of-the-art reactors for the pyrolysis of silane and chlorosilanes are set forth in, for example, U.S. Patent Nos. 3,147,141; 4,147,814; and 4,150,168, which are incorporated herein by reference as if set out in full. It is generally more desirable to prepare the polycrystalline silicon rods by silane pyrolysis so as to avoid the complications caused by the formation of chloride by-products when pyrolyzing chlorosilanes.

The pyrolysis of silane to form silicon and hydrogen, or a chlorosilane which produces chloride-containing compounds such as HCl, SiHCl₂ or the like as well as hydrogen, is performed in a reactor consisting of a series of heated filaments, generally silicon rods, surrounded by cooled surfaces. Typically, the filaments are heated by introducing an electrical current through the filament. The process is started with the silicon filament at ambient temperature.

The polycrystalline silicon is produced by heterogeneous decomposition of the silane, chlorosilane or mixtures thereof on the glowing hot silicon filament rod. The reaction deposits silicon on the surface of the rod and releases hydrogen gas if the silicon is formed by the decomposition of silane, or hydrogen gas in conjunction with other chloride-containing by-product compounds if the source of silicon is chlorosilane.

One of the major objectives in the production of polycrystalline silicon is to produce a silicon rod which is as pure as possible. Even slight amounts of contaminants have a major impact on the efficacy of the silicon chips which are ultimately made from this precursor polycrystalline silicon. The prior art techniques for making polycrystalline silicon have had the problem of coping with various contaminants, including carbon. The present invention is specifically directed to reducing or eliminating the amount of carbon contaminant which may be incorporated in a polycrystalline silicon rod during the production process when using a graphite chuck.

As stated above, the gaseous silicon compound which is used as a source for the silicon, is thermally decomposed by means of a heated starter filament. This filament, typically made of a silicon seed rod, is generally heated by passing an electrical current therethrough. Accordingly, this filament must be held securely in place so as to accommodate the growing polysilicon rod that is being deposited thereon while simultaneously being capable of having an electrical current passed through it. Typically, a graphite chuck has been utilized by the prior art in order to accomplish both of these objectives. The graphite chuck is made so that the starter filament may be securely mounted on it, the chuck can be positioned and seated on an electrode which provides the necessary electrical power for the required current, and, most importantly, the chuck is electrically conductive so as to be able to conduct the current from the electrode to the filament.

DE-A-40 41901, corresponding to US-A-5 284 640 and pyrolytic graphite disclose that the graphite chuck is the source of the carbon contamination in the polysilicon product. In particular, it recites that the hydrogen being formed as a by-product as a result of the pyrolysis of the gaseous silicon compounds, such as silane or chlorosilane, actually reacts with the graphite, i.e., carbon, to form methane. This methane, in turn then decomposes when it contacts the heated silicon rod to form carbon and yet additional hydrogen. It is this carbon which finds its way into the polysilicon rod as a contaminant. DE-A-40 41901, corresponding to US-A-5 284 640 discloses a graphite chuck which is suitable for mounting an elongated starter filament in the production of polycrystalline silicon rods by the pyrolytic decomposition of a gaseous silicon compound on said starter filament and said graphite chuck having a hydrogen impervious outer coated layer of a material selected from the group consisting of silicon carbide, pyrolytic graphite polycrystalline silicon, tantalum, titanium, tungsten, silicon nitride, silicon oxide, molybdenum, and combinations thereof.

DE-A-40 41902, corresponding to US-A-5 277 934 discloses a graphite chuck which is suitable for mounting an elongated starter filament in the production of polycrystalline silicon rods by the pyrolytic decomposition of a gaseous silicon compound on said starter filament and said graphite chuck having an outer coated layer of pyrolytic graphite.

Coatings of a graphite chuck using pyrolytic carbon or silicon carbide have been found to minimize this carbon contaminant problem but these coatings are applied using vapor deposition processes and are costly to implement, difficult to control and impractical to apply to very large chucks.

In prior art unrelated to the production of polycrystalline silicon by means of pyrolyzing silane or chlorosilanes, graphite articles have been coated with various materials. For example, in U.S. Patent No. 3,406,044 issued to Harris, it is taught that silicon wafers may be surface treated in epitaxial silicon furnaces. The silicon wafers are placed upon a graphite heating element forming part of the epitaxial silicon furnace and then heated. Harris teaches that these graphite heating elements are rather porous and when subjected to high temperatures will emit considerable amounts of gas. Harris further discloses that this gas often reacts with the silicon wafer causing surface imperfections. Here, in order to prevent the escape of such gases from the graphite material, a first layer of silicon is provided on the graphite followed by a second layer of silicon carbide.

In U.S. Patent No. 4,621,017 issued to Chandler, et al., graphite articles are provided with a silicon carbide coating which is then treated with aluminum phosphate, which infiltrates into both the graphite as well as the silicon carbide overcoat. The purpose of such a coating is to provide a corrosion and wear resistant graphite article which can be rendered substantially resistant to both corrosion, in the form of oxidation, and wear created by the flow of elevated temperature fluids.

It is an object of the present invention to provide a graphite chuck coated with a glassy carbon layer that will prevent the reaction of the carbon in the chuck with hydrogen by-product from the pyrolysis of a gaseous silicon compound so that a polysilicon rod can be produced that is substantially a carbon-free polysilicon rod.

It is another object of the present invention to provide a method for producing a glassy carbon coated graphite chuck that can be used in the production of substantially carbon-free polysilicon rods.

The foregoing and additional objects will become more fully apparent from the following description.

### Summary of the Invention

The invention relates to a graphite chuck suitable for mounting an elongated starter filament in the production of polycrystalline silicon rods by the pyrolytic decomposition of a gaseous silicon compound on said starter filament in which said graphite chuck has a glassy carbon outer layer formed from a thermoset organic resin and wherein said glassy carbon layer is impervious to hydrogen.

The invention also relates to a method for making a glassy coated graphite chuck comprising the steps:
(a) preparing a carbon chuck having.a first opening at one end suitable for mounting an elongated starter filament;
(b) depositing on said graphite chuck a layer of a non-graphitizing organic thermosetting resin; and
(c) heating the coated carbon chuck at a temperature and time period sufficient to thermoset the resin and then converting the thermoset resin to glassy carbon by heating to above 500°C in an inert gas atmosphere or in a halogen gas atmosphere.

In some applications, the chuck could be a graphite chuck before depositing the outer layer of resin or the chuck could be a carbon chuck that could be graphitized after the outer layer is deposited on the chuck by heating the coated chuck to the graphitization temperature of the chuck and wherein such temperature could also convert the resin to glassy carbon.

In some applications two or more separate layers of the thermosetting resin may be applied to the graphite chuck to obtain a desired coating thickness. The glassy carbon coated graphite chuck can then be used in a method for making substantially carbon-free polycrystalline silicon which comprises the mounting of a starter filament on said coated graphite chuck and then heating said starter filament and pyrolyzing a gaseous silicon compound onto said heated starter filament while maintaining the heated starter filament at a temperature sufficient to effect decomposition of the gaseous silicon compound to form and deposit polycrystalline silicon on said heated starter filament. Some gaseous silicon compounds will produce a by-product of hydrogen and the glassy carbon outer layer will prevent the by-product of hydrogen from reacting with the graphite of the chuck to form methane which could decompose as carbon on the deposited polycrystalline silicon.

As used herein, glassy carbon is a monolithic non-graphitizable carbon with a very high isotropy of the structure and physical properties and with a very low permeability for gases and liquid. The glassy carbon also has a pseudo-glassy appearance. Glassy carbon can be formed from a non-graphitizing carbon-containing thermosetting resin such as synthetic or natural resins. Thermosetting resins are resins that become rigid on heating and cannot be softened upon reheating. The principal groups of resins suitable for use in this invention are the phenolics, urethanes and polymers of furfural and furfuryl alcohol. The preferred phenolics are phenol-formaldehyde and resorcinol-formaldehyde. Furan based polymers derived from furfural or furfuryl alcohol are also suitable for use in this invention. The resin system should preferably give a carbon yield in excess of about 20% and have a viscosity below about 200-300 cps. In addition to solutions of phenolics in furfural and furfuryl alcohol, straight furfural or furfuryl alcohol can be used with a catalyst. For example, a solution of furfural and an acid catalyst could be coated on the surface of the graphite chuck and then cured and carbonized.

The resin coating of this invention does not require a separate heat treatment step since the resin coating could be carbonized during the regular graphitization of the carbon chuck. The resin coating may be deposited by any conventional manner such as painting, spraying, dipping, or infiltration or the like. The resin can be applied directly onto the graphite chuck from a resin solution so that uniformity and thickness of the coating can be accurately controlled. For most applications, the thickness of the glassy carbon layer can be from about 12.7 µm to 635 µm (0.5 mils to 25 mils), preferably from about 25.4 µm to 254 µm (1 mil to 10 mils). The temperature for thermosetting the resin will depend upon the particular resin used to coat the graphite chuck. For most applications a temperature from 100°C to 300°C could be used for a time period from 1 to 10 hours. After thermosetting the resin, the chuck can be recoated to build up a thicker overall layer and thereby assure more uniformity in the deposited layer. The coated chuck can then be further heated to convert the thermoset resin to a glassy carbon. The heat treatment to convert the thermoset resin to glassy carbon can preferably be from 500°C to about 3000°C depending on the particular composition of the coated layer and chuck substrate. If the coating is used on a carbon chuck which has not been graphitized, then it will be necessary to heat treat the coated carbon chuck to above 2500°C to convert the carbon chuck to a conductive graphite chuck. The coated layer will not be converted to graphite since it is a non-graphitizing carbon resin. If the chuck is a graphite chuck then most preferably the thermoset resin can be heated from 500°C to 2000°C to convert the resin to glassy carbon. The carbon coated graphite chucks can also be further purified by a heat treatment in a halogen gas atmosphere at a temperature from about 1400°C to 1800°C. An added benefit of using an organic resin is that the coated graphite chuck will be all carbon unlike a silicon carbide coated graphite chuck. This will result in a chuck with relatively high electrical conductivity.

The glassy carbon coating that is provided to the outer surface of the graphite chuck will prevent diffusion of reactant products or by-products of the polysilicon production process into the graphite chuck and substantially eliminate the deposition of graphite from the chuck into the silicon product. Moreover, the glassy carbon coating that is provided as an outer protective layer will be effective in substantially preventing hydrogen from being able to come into contact with the interior graphite of the chuck and reacting therewith. The glassy carbon coating will also provide protection from flaking, scratching and other defects in the graphite chuck. As stated above, two or more coatings can be applied to the graphite chuck to deposit a desired layer of the glassy carbon. Preferably, the outer glassy carbon layer can be applied to completely cover the graphite chuck since the glassy carbon is a relatively good conductor.

### BRIEF DESCRIPTION OF THE DRAWINGS

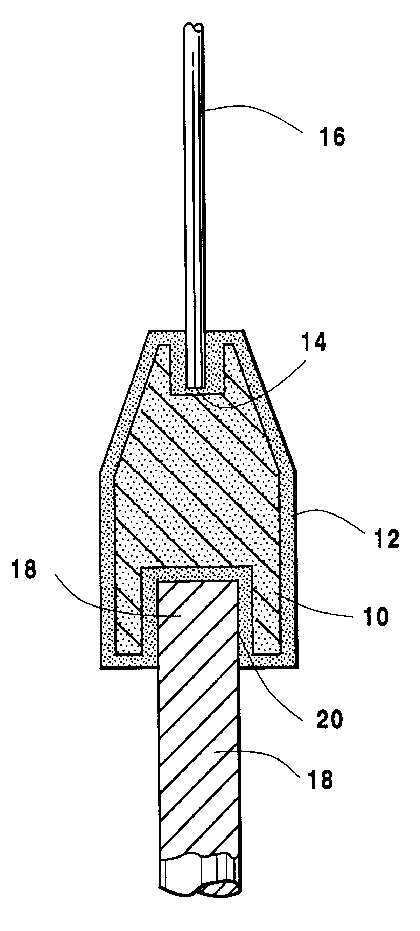

The Figure is a cross-sectional diagram of a graphite chuck made in accordance with the present invention showing the starter filament mounted thereon and also showing the chuck seated on an electrode.

### DETAILED DESCRIPTION OF THE INVENTION

The structure or design of the graphite chuck is not narrowly critical to the present invention. Generally, the graphite chuck, as its name implies, must be able to securely hold the starter filament in place, and be able to be positioned on the electrode.

Referring to the Figure, a graphite chuck 10 is shown with a glassy carbon layer 12. This graphite chuck 10 is typically provided with a channel 14 which allows for the mounting of starter filament 16. The clearance between filament 16 and channel 14 of graphite chuck 10 is just enough to allow the introduction of the filament 16 but still provide a snug and secure fit.

Generally, the bottom of the chuck is provided with a means for it to be able to be seated and positioned on electrode 18 which provides the electrical power for the pyrolysis process. Typically, the graphite chuck 10 is provided with a channel 20 shown in the diagram to allow seating of the graphite chuck 10 on the electrode 18.

### EXAMPLE

A graphite chuck of the type shown in the Figure was vacuum dried and then dipped into a 50% solution of a liquid resol phenolic resin in furfural. The properties of the solution were:
Specific Gravity = 1.20
Viscosity = 20 cps at 22°C
Modified MCC = 27.2%

The graphite chuck was immersed for about 30 minutes in the solution, then removed and allowed to drip-dry in air, and then placed on a paper towel. After drying, the weight increase or pickup from the coating solution on the chuck was found to be 5.3%. The chuck was then cured at 150°C in argon for an hour. About 50% of the coating was volatilized during curing so that the final weight increase or pickup from the coating was 2.3%.

A second dipping was done following the same procedure as the first. The weight increase from the coating after the second dipping was an additional 2.8%. After curing to 150°C, the weight increase of the coating was an additional 1.2%.

The coating was then heated to 250°C in argon and held for an hour at 250°C. The final weight increase from the coating was 3.4%. The chuck was nonporous as demonstrated by H₂O immersion (i.e., no bubbling). The final density of the coated chuck after the 250°C cure was 1.63 g/cm³. The coated chuck was then heat treated to 1600°C at a rate of 250°C per hour in a nitrogen atmosphere with chlorine gas added at the final stage to effect purification and ash removal. The purified graphite chuck produced contained less than 10 parts per million of ash.

The glassy carbon coated graphite chuck produced could be used to mount a starter filament in the production of polycrystalline silicon rods by the pyrolytic decomposition of a gaseous compound on said starter filament.

In a test run, the coated chuck produced was used to produce silicon and when the silicon produced was compared to silicon produced from an identical chuck except it was not coated, it was found to contain at least 5 times less carbon contamination.

While the present invention has been described with reference to many particular details thereof, it is not intended that these details shall be construed as limiting the scope of this invention.

## Claims

1. A graphite chuck suitable for mounting an elongated starter filament in the production of polycrystalline silicon rods by the pyrolytic decomposition of a gaseous silicon compound on said starter filament wherein said graphite chuck has a glassy carbon outer layer formed from a thermoset organic resin.

2. The graphite chuck of claim 1 wherein the thermoset organic resin is selected from the group consisting of phenolics, urethanes, polymers of furfural and furfuryl alcohol.

3. The graphite chuck of claim 2 wherein the thermoset organic resin is phenolic.

4. The graphite chuck of claim 1 wherein the thickness of the glassy carbon outer layer is from about 0.5 mil to about 25 mils.

5. The graphite chuck of claim 1 wherein the glassy carbon outer layer covers the complete outer surface of the graphite chuck.

6. A method for making a glassy carbon coated carbon chuck comprising the steps.
(a) preparing a carbon chuck having a first opening at one end suitable for mounting an elongated starter filament;
(b) depositing on said chuck a layer of a non-graphitizing organic thermosetting resin; and
(c) heating the coated chuck at a temperature and time period sufficient to thermoset the resin and further heating the coated chuck in an inert atmosphere or a halogen-containing atmosphere to convert the thermoset resin to glassy carbon.

7. The method of claim 6 wherein in step (a) the carbon chuck is a graphite chuck.

8. The method of claim 6 wherein after step (c) the coated carbon chuck is further heated to graphitize the carbon chuck to produce a graphite chuck coated with an outer layer of glassy carbon.

9. The method of claim 6 wherein steps (b) and (c) are repeated at least once.

10. The method of claim 9 wherein in step (a) the carbon chuck is a graphite chuck.

11. The method of claim 9 wherein after the final step (c) the coated carbon chuck is further heated to graphitize the carbon chuck to produce a graphite chuck coated with an outer layer of glassy carbon.

12. The method of claim 7 wherein in step (b) the non-graphitizing organic thermosetting resin is at least one resin selected from the group consisting of phenolics, urethanes, polymers of furfural, and furfuryl alcohol.

13. The method of claim 6 wherein the layer of glassy carbon deposited is between about 12.7 µm and about 635 µm (about 0.5 mils and about 25 mils).

14. The method of claim 13 wherein in step (b) the non-graphitizing organic thermosetting resin is a phenolic resin.

15. The method of claim 7 wherein the following steps are added:
(e) mounting a starter filament into said first opening in the coated graphite chuck;
(f) heating said starter filament and pyrolyzing a gaseous silicon compound onto said heated starter filament while maintaining the heated starter filament at a temperature sufficient to effect decomposition of the gaseous silicon compound to form and deposit polycrystalline silicon on said heated starter filament and produce by-products and wherein said glassy carbon outer layer prevents the by-products from diffusion into the interior of the graphite chuck and reacting with the graphite of the chuck to form products which are contaminants to the polycrystalline silicon.

16. The method of claim 15 wherein the by-product is hydrogen and the glassy carbon outer layer prevents the hydrogen from reacting with the graphitic portion of the chuck to form methane which could decompose to carbon and contaminate the deposited polycrystalline silicon.

17. The method of claim 16 wherein the gaseous silicon compound is selected from the group consisting of silane, chlorosilane and mixtures thereof.

18. The method of claim 8 wherein the following steps are added:
(e) mounting a starter filament into said first opening in the coated graphite chuck;
(f) heating said starter filament and pyrolyzing a gaseous silicon compound onto said heated starter filament while maintaining the heated starter filament at a temperature sufficient to effect decomposition of the gaseous silicon compound to form and deposit polycrystalline silicon on said heated starter filament and produce by-products and wherein said glassy carbon outer layer prevents the by-products from diffusing into the interior of the graphite chuck and reacting with the graphite of the chuck to form products which are contaminants to the polycrystalline silicon.

19. The method of claim 18 wherein the by-product is hydrogen and the glassy carbon outer layer prevents the hydrogen from reacting with the graphitic portion of the chuck to form methane which could decompose to carbon and contaminate the deposited polycrystalline silicon.

20. The method of claim 19 wherein the gaseous silicon compound is selected from the group consisting of silane, chlorosilane and mixtures thereof.

## Patentansprüche

1. Graphitspannvorrichtung, an der ein längliches Starterfilament bei der Herstellung von polykristallinen Siliciumstäben durch pyrolytische Zersetzung einer gasförmigen Siliciumverbindung an diesem Starterfilament angebracht werden kann, wobei die Graphitspannvorrichtung eine aus einem wärmehärtbaren organischen Harz gebildete, äußere glasige Kohlenstoffschicht enthält.

2. Graphitspannvorrichtung nach Anspruch 1, wobei das wärmehärtbare organische Harz ausgewählt ist aus der Gruppe von Phenolharzen, Urethanharzen, Furfural- und Furfurylalkoholpolymeren.

3. Graphitspannvorrichtung nach Anspruch 2, wobei das wärmehärtbare organische Harz ein Phenolharz ist.

4. Graphitspannvorrichtung nach Anspruch 1, wobei die Dicke der äußeren glasigen Kohlenstoffschicht ungefähr 12,7 µm (0,5 mil) bis ungefähr 635 um (25 mils) beträgt.

5. Graphitspannvorrichtung nach Anspruch 1, wobei die äußere glasige Kohlenstoffschicht die gesamte äußere Oberfläche der Graphitspannvorrichtung bedeckt.

6. Verfahren zur Herstellung einer mit glasigem Kohlenstoff beschichteten Kohlenstoffspannvorrichtung, das folgende Schritte umfaßt:
a) Herstellen einer Kohlenstoffspannvorrichtung mit einer ersten Öffnung an einem Ende, an der ein längliches Starterfilament angebracht werden kann;
b) Aufbringen einer Schicht aus nichtgraphitisierendem, organischen wärmehärtbaren Harz auf diese Spannvorrichtung; und
c) Erhitzen der beschichteten Spannvorrichtung bei einer Temperatur und für einen Zeitraum, die ausreichen, um das Harz in der Wärme zu härten, und weiteres Erhitzen der beschichteten Spannvorrichtung in einer inerten Atmosphäre oder einer halogenhaltigen Atmosphäre, um das wärmegehärtete Harz in glasigen Kohlenstoff zu überführen.

7. Verfahren nach Anspruch 6, wobei die Kohlenstoffspannvorrichtung in Schritt a) eine Graphitspannvorrichtung ist.

8. Verfahren nach Anspruch 6, wobei die beschichtete Kohlenstoffspannvorrichtung nach Schritt c) weiter erhitzt wird, um die Kohlenstoffspannvorrichtung zu graphitisieren, um eine mit einer äußeren Schicht aus glasigem Kohlenstoff beschichtete Graphitspannvorrichtung zu erzeugen.

9. Verfahren nach Anspruch 6, wobei die Schritte b) und c) mindestens einmal wiederholt werden.

10. Verfahren nach Anspruch 9, wobei die Kohlenstoffspannvorrichtung in Schritt a) eine Graphitspannvorrichtung ist.

11. Verfahren nach Anspruch 9, wobei die beschichtete Kohlenstoffspannvorrichtung nach dem letzten Schritt c) weiter erhitzt wird, um die Kohlenstoffspannvorrichtung zu graphitisieren, um eine mit einer äußeren Schicht aus glasigem Kohlenstoff beschichtete Graphitspannvorrichtung zu erzeugen.

12. Verfahren nach Anspruch 7, wobei das nichtgraphitisierende, organische wärmehärtbare Harz in Schritt b) mindestens ein Harz ist, das ausgewählt ist aus der Gruppe von Phenolharzen, Urethanharzen, Furfural- und Furfurylalkoholpolymeren.

13. Verfahren nach Anspruch 6, wobei die aufgetragene Schicht aus glasigem Kohlenstoff zwischen ungefähr 12,7 µm (0,5 mil) und ungefähr 635 um (25 mils) liegt.

14. Verfahren nach Anspruch 13, wobei das nichtgraphitisierende, organische wärmehärtbare Harz in Schritt b) ein Phenolharz ist.

15. Verfahren nach Anspruch 7, wobei die folgenden Schritte hinzugefügt werden:
e) Anbringen eines Starterfilamentes in der ersten Öffnung der beschichteten Graphitspannvorrichtung;
f) Erhitzen des Starterfilamentes und Pyrolisieren einer gasförmigen Siliciumverbindung auf dem erhitzten Starterfilament, während das erhitzte Starterfilament bei einer Temperatur belassen wird, die ausreicht, um die Zersetzung der gasförmigen Siliciumverbindung herbeizuführen, wobei polykristallines Silicium gebildet und auf dem erhitzten Starterfilament abgeschieden wird und Nebenprodukte erzeugt werden und wobei die äußere glasige Kohlenstoffschicht verhindert, daß die Nebenprodukte in das Innere der Graphitspannvorrichtung diffundieren und mit dem Graphit der Spannvorrichtung unter Bildung von Produkten reagieren, die Verunreinigungen für das polykristalline Silicium darstellen.

16. Verfahren nach Anspruch 15, wobei das Nebenprodukt Wasserstoff ist und die äußere glasige Kohlenstoffschicht verhindert, daß der Wasserstoff mit dem Graphitanteil der Spannvorrichtung unter Bildung von Methan reagiert, das den Kohlenstoff zersetzen und das abgeschiedene polykristalline Silicium verunreinigen könnte.

17. Verfahren nach Anspruch 16, wobei die gasförmige Siliciumverbindung ausgewählt ist aus der Gruppe von Silan, Chlorsilan und deren Mischungen.

18. Verfahren nach Anspruch 8, wobei die folgenden Schritte hinzugefügt werden:
e) Anbringen eines Starterfilamentes in der ersten Öffnung der beschichteten Graphitspannvorrichtung;
f) Erhitzen des Starterfilamentes und Pyrolisieren einer gasförmigen Siliciumverbindung auf dem erhitzten Starterfilament, während das erhitzte Starterfilament bei einer Temperatur belassen wird, die ausreicht, um die Zersetzung der gasförmigen Siliciumverbindung herbeizuführen, wobei polykristallines Silicium gebildet und auf dem erhitzten Starterfilament abgeschieden wird und Nebenprodukte erzeugt werden und wobei die äußere glasige Kohlenstoffschicht verhindert, daß die Nebenprodukte in das Innere der Graphitspannvorrichtung diffundieren und mit dem Graphit der Spannvorrichtung unter Bildung von Produkten reagieren, die Verunreinigungen für das polykristalline Silicium darstellen.

19. Verfahren nach Anspruch 18, wobei das Nebenprodukt Wasserstoff ist und die äußere glasige Kohlenstoffschicht verhindert, daß der Wasserstoff mit dem Graphitanteil der Spannvorrichtung unter Bildung von Methan reagiert, das den Kohlenstoff zersetzen und das abgeschiedene polykristalline Silicium verunreinigen könnte.

20. Verfahren nach Anspruch 19, wobei die gasförmige Siliciumverbindung ausgewählt ist aus der Gruppe von Silan, Chlorsilan und deren Mischungen.

## Revendications

1. Mandrin en graphite convenant pour le montage d'un filament allongé d'amorçage dans la production de baguettes de silicium polycristallin par décomposition pyrolytique d'un composé gazeux de silicium sur ce filament d'amorçage, ce mandrin en graphite portant une couche externe de carbone vitreux formée à partir d'une résine organique thermodurcie.

2. Mandrin en graphite suivant la revendication 1, dans lequel la résine organique thermodurcie est choisie dans le groupe consistant en résines phénoliques, uréthannes, polymères de furfural et d'alcool furfurylique.

3. Mandrin en graphite suivant la revendication 2, dans lequel la résine organique thermodurcie est phénolique.

4. Mandrin en graphite suivant la revendication 1, dans lequel l'épaisseur de la couche externe de carbone vitreux va d'environ 0,5 in/1000 à environ 25 in/1000.

5. Mandrin en graphite suivant la revendication 1, dans lequel la couche externe de carbone vitreux recouvre toute la surface externe du mandrin en graphite.

6. Procédé de production d'un mandrin en carbone revêtu de carbone vitreux, qui comprend les étapes consistant :
(a) à préparer un mandrin en carbone présentant une première ouverture à une extrémité convenant pour le montage d'un filament allongé d'amorçage ;
(b) à déposer sur ce mandrin-une couche d'une résine thermodurcissable organique non graphitisante ;
(c) à chauffer le mandrin revêtu à une température et pendant une durée suffisantes pour obtenir le durcissement thermique de la résine et à poursuivre le chauffage du mandrin revêtu dans une atmosphère inerte ou dans une atmosphère contenant un halogène pour convertir la résine thermodurcie en carbone vitreux.

7. Procédé suivant la revendication 6, dans l'étape (a) duquel le mandrin en carbone est un mandrin en graphite.

8. Procédé suivant la revendication 6, dans lequel, après l'étape (c), le mandrin en carbone revêtu est encore chauffé afin d'être transformé en graphite, pour produire un mandrin en graphite revêtu d'une couche externe de carbone vitreux.

9. Procédé suivant la revendication 6, dans lequel les étapes (b) et (c) sont répétées au moins une fois.

10. Procédé suivant la revendication 9, dans lequel le mandrin en carbone dans l'étape (a) est un mandrin en graphite.

11. Procédé suivant la revendication 9, dans lequel, après l'étape finale (c), le mandrin en carbone revêtu est encore chauffé afin d'être transformé en graphite pour produire un mandrin en graphite revêtu d'une couche externe de carbone vitreux.

12. Procédé suivant la revendication 7, dans l'étape (b) duquel la résine thermodurcissable organique non graphitisante consiste en au moins une résine choisie dans le groupe consistant en résines phénoliques, uréthannes, polymères de furfural et d'alcool furfurylique.

13. Procédé suivant la revendication 6, dans lequel la couche de carbone vitreux déposée est comprise entre environ 12,7 µm et environ 635 µm (environ 0,5 in/1000 et environ 25 in/1000).

14. Procédé suivant la revendication 13, dans l'étape (b) duquel la résine organique thermodurcissable non graphitisante est une résine phénolique.

15. Procédé suivant la revendication 7, dans lequel sont ajoutées les étapes suivantes, qui consistent :
(e) à monter un filament d'amorçage dans une première ouverture ménagée dans le mandrin en graphite revêtu ;
(f) à chauffer ce filament d'amorçage et à pyrolyser un composé gazeux de silicium sur ce filament d'amorçage chauffé tout en le maintenant à une température suffisante pour effectuer la décomposition du composé gazeux de silicium afin de former et de déposer du silicium polycristallin sur ce filament chauffé d'amorçage et pour former des sous-produits, et cette couche externe de carbone vitreux empêche les sous-produits de diffuser à l'intérieur du mandrin en graphite et de réagir avec le graphite du mandrin pour former des produits qui sont des impuretés vis-à-vis du silicium polycristallin.

16. Procédé suivant la revendication 15, dans lequel le sous-produit est l'hydrogène et la couche externe de carbone vitreux empêche l'hydrogène de réagir avec la partie graphitique du mandrin pour former du méthane qui pourrait se décomposer en carbone et contaminer le silicium polycristallin déposé.

17. Procédé suivant la revendication 16, dans lequel le composé de silicium gazeux est choisi dans le groupe consistant en silane, chlorosilane, et leurs mélanges.

18. Procédé suivant la revendication 8, dans lequel sont ajoutées les étapes suivantes, qui consistent :
(e) à monter un filament d'amorçage dans la première ouverture mentionnée ménagée dans le mandrin en graphite revêtu ;
(f) à chauffer ce filament d'amorçage et à pyrolyser un composé gazeux de silicium sur ce filament d'amorçage chauffé tout en maintenant ce dernier à une température suffisante pour effectuer la décomposition du composé gazeux de silicium afin de former et de déposer du silicium polycristallin sur ce filament d'amorçage chauffé et de former des sous-produits, la couche externe de carbone vitreux en question empêchant les sous-produits de diffuser à l'intérieur du mandrin en graphite et de réagir avec le graphite du mandrin pour former des produits qui sont des impuretés vis-à-vis du silicium polycristallin.

19. Procédé suivant la revendication 18, dans lequel le sous-produit est l'hydrogène et la couche externe de carbone vitreux empêche l'hydrogène de réagir avec la partie graphitique du mandrin en formant du méthane qui pourrait se décomposer en carbone et contaminer le silicium polycristallin déposé.

20. Procédé suivant la revendication 19, dans lequel le composé gazeux de silicium est choisi dans le groupe consistant en silane, chlorosilane et leurs mélanges.
